# EUROPEAN PATENT SPECIFICATION

(11) **EP 0 179 491 B1**
(45) Date of publication and mention of the grant of the patent: **24.03.1993**
(21) Application number: 85113615.0
(22) Date of filing: 25.10.1985
(51) Int. Cl.: H01L 21/20, H01L 21/268

(54) **Formation of single-crystal silicon layer by recrystallization**
Herstellung einer monokristallinen Schicht aus Silicium durch Rekristallisation
Procédé pour la formation d'une couche monocristalline en silicium par recristallisation

(30) Priority: 25.10.1984 JP 224625/84
(43) Date of publication of application: 30.04.1986
(73) Proprietor: NEC CORPORATION, Tokyo (JP)
(72) Inventor: Egami, Koji, Minato-ku Tokyo (JP)
(74) Representative: Glawe, Delfs, Moll & Partner

(56) References cited:
- FR-A- 2 537 607
- JOURNAL OF APPLIED PHYSICS, vol. 55, no. 6, 15th March 1984, part 1, pages 1607-1609, American Institute of Physics, New York, US; S. KAWAMURA et al.: "Laser recrystallization of Si over SiO2 with a heat-sink structure"
- APPLIED PHYSICS LETTERS, vol. 45, no. 8, 15th October 1984, pages 854-856, American Institute of Physics, New York, US; K. EGAMI et al.: "Strong [100] texture formation of polycrystalline silicon films on amorphous insulator by laser recrystallization"
- JOURNAL OF THE ELECTROCHEMICAL SOCIETY, vol. 128, no. 9, September 1981, pages 1981-1986, Manchester, New Hampshire, US; H.W. LAM et al.: "Single crystal silicon-on-oxide by a scanning CW laser induced lateral seeding process"

## Description

### Background of the Invention:

The present relates to a semiconductor structure having a single-crystal silicon layer on an insulating coating substrate in which semiconductor devices are to be provided, and more particularly to formation of such a single-crystal silicon layer by recrystallization.

Recently, various technologies for forming a single-crystal silicon layer on an insulating coating substrate from a polycrystalline silicon layer by laser beam have been developed. For example, in "Japanese Journal of Applied Physics" Vol. 19, No. 1, January, 1980 pp. L23-26, M. TAMURA, et al. disclose a technology in which a portion of a single-crystal silicon substrate is used as a seed. Namely, an insulating film is formed on the single crystal silicon substrate and an aperture is opened in the insulating film to expose the portion of the substrate. A polycrystalline silicon film is deposited on the insulating film and in the aperture. Thereafter, a laser beam is irradiated on a part of the polycrystalline silicon film in the aperture and scanned on other parts of the polycrystalline silicon film on the insulating film. Then, a single crystal silicon film of a large grain size can be obtained from the polycrystalline silicon film on the insulating film by using the exposed portion of the single crystal silicon substrate in the aperture as a seed. Semiconductor devices can be formed in the single crystal silicon film recrystallized from the polycrystalline silicon film by the laser power, and in this case a heat produced by the semiconductor devices can be effectively dispersed because the silicon substrate has a high thermal conductivity. However, this technology has following problems. Namely, the material of the substrate is restricted to single crystal silicon because it must be used as the seed. The seed area, that is, the portion within the aperture must be usually prepared in the substrate. Further, the conditions of the laser annealing must be changed on the seed area and on the recrystallized portions.

A method for manufacturing a single crystal silicon layer according to the preamble of claim 1 is disclosed in J. Appl. Phys. 55, No. 6, Part 1, p.1607-1609, "Laser recrystallization ...". According to this document a single crystal layer is formed in a particular area with polycrystalline grains formed in the surrounding region. These grains formed in the surrounding region have a mixed orientation.

It is an object of the invention to provide a silicon layer structure which has a single crystal silicon layer on a substrate of a wide variety of materials.

It is another object of the present invention to provide a method for forming a single crystal silicon layer by recrystallization using as seed crystals larger grain polycristalline layers positioned on an insulating film on an insulating coating substrate so that the material of the substrate is not restricted to single crystal silicon.

Another object of the present invention is to provide a method of forming a single crystal silicon layer by continuously scanning laser beam on the seed area and the area in which the single crystal silicon film is to be formed without changing its conditions irrespective of the irradiating areas.

These objects are achieved by a method of manufacturing a single crystal silicon layer as defined in claim 1; the dependent claims are related to further developments of the invention.

In the first part of the polycrystalline silicon layer, the annealing width by the laser beam widely spread in the polycrystalline silicon layer because the silicon layer is a high thermal conductivity material and under the first part of the silicon layer the thick insulating film of low thermal conductivity material is provided. The conditions of the laser beam such as scan speed, power, spot area, etc. are determined such that the spreaded annealing region in the first part becomes a state consisting of both solid state and liquid state. In this case, a large amount of silicon grains having 〈100〉 axis in a direction perpendicular to the upper surface of the insulating film and perpendicular to the upper surface of silicon layer per se, that is, a strong 〈100〉 texture are produced. The silicon grains can be used as a seed for forming a single crystal silicon of long size in a second part of the silicon layer above the second section of the insulating film and under the anti-reflection film against the laser beam. The laser beam is scanned from the first part to the second part with the same laser beam diameter (spot area), scanning speed and laser power. However, in the second part of the silicon layer, the efficiency of introducing the laser power into the polycrystalline silicon layer is enhanced because of existing the anti-reflection film. Then, the polycrystalline silicon layer in the second part becomes a perfect molten state. Further, the second part is positioned above the thin insulating film and the substrate of high thermal conductivity is positioned under the thin insulating film. Therefore, the annealing region in the second part is spreaded smaller than that of the first part. In these conditions, the polycrystalline silicon layer in the second part becomes zone melt state and recrystallized to form a single silicon crystal in its entire thickness of long size and having 〈100〉 axis in a direction perpendicular to the upper surface of the insulating film. As mentioned above, the single silicon crystal in the second part can be produced by using the strong 〈100〉 texture in the first part as the seed. The anti-reflection film may be made of a silicon nitride layer or composed film of a silicon dioxide layer and a silicon nitride layer on the silicon dioxide layer. The laser may be continuous wave (CW)-Aᵣ⁺ laser, CW-CO₂ laser or CW-YAG laser. When CW-Aᵣ⁺ laser is used, the thickness of the silicon nitride layer as the anti-reflected film may be selected from the value of 60 nm ± 20 nm (600 Å ± 200 Å), 160 nm ± 20 nm (1600 Å ± 200 Å), 300 nm ± 20 nm (3000 Å ± 200 Å) or 420 nm ± 20 nm (4200 Å ± 200 Å). If the composed film is used as the anti-reflection film against CW-Aᵣ⁺ laser, the thickness may be selected such that the silicon dioxide layer is of 170 nm ± 10 nm (1700 Å ± 100 Å) and the silicon nitride layer is of 60 nm ± 10 nm (600 Å ± 100 Å), or the silicon dioxide layer is of 170 nm ± 10 nm (1700 Å ± 100 Å) and the silicon nitride layer is of 180 nm ± 10 nm (1800 Å ± 100 Å).

Favorably, the thickness of the silicon layer ranges from 0.5 µm to 1.0 µm. The lower limit is defined for forming semiconductor devices in the single crystal silicon layer, and the upper limit is defined for forming the strong 〈100〉 texture in the first part and the long single silicon crystal in the second part in its whole thickness. Further, the polycrystalline silicon layer is favorably deposited by reduced-pressure CVD process under a temperature of 670°C to 730°C. This is because the silicon layer formed under the temperature of 670°C to 730°C is effectively produced the strong 〈100〉 texture with the laser beam process. The thermal conductivity of the material of the body, that is, substrate is favorably 0.2 W/cm·deg. or more, and that of the insulating film formed on the body is favorably 0.05 W/cm·deg.

### Brief Description of Drawings:

Fig. 1 is a perspective view showing an embodiment of the present invention;
Fig. 2A is a plan view showing the embodiment, and Fig. 2B is a cross-sectional view taken along line B-B' in Fig. 2A as viewed in the direction of arrows.

### Detailed Description of the Embodiment:

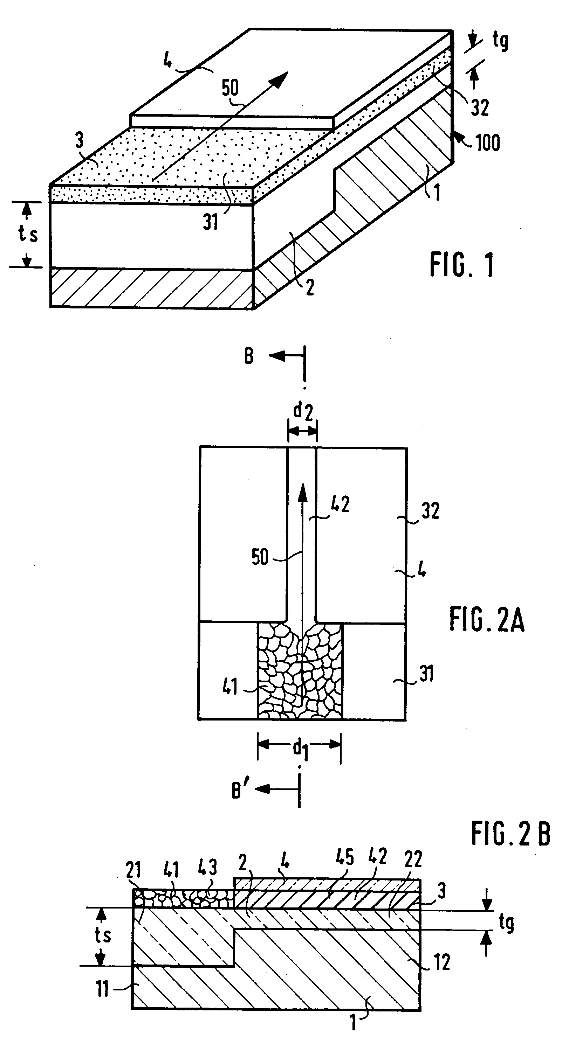

Figs. 1 and 2 show only a part 100 of a single-crystal silicon substrate 1 on which a recrystallized layer of the present invention is to be formed. More particularly, the substate 1 has a high thermal conductivity of 1.5 W/cm·deg. and the region has 3 x 3 mm² area in the plan view. The material of the substrate may be replaced by, for example, aluminum nitride which has a high thermal conductivity of 1 to 2 W/cm·deg. The part 100 comprises the first portion 11 of 3 x 0.2 mm² area and the second portion 12 of 3 x 2.8 mm² area.

The upper surface of the first portion 11 is etched away by using conventional photolithographic and dry etching techniques so that the upper surface of the first portion 11 becomes lower level of 3.6 µm than the upper surface of the second portion 12. Next, a first silicon dioxide layer of 4 µm thickness is entirely formed by CVD method. Then, by chemical and mechanical methods, a part of the first silicon dioxide layer is removed so that the upper surface of the second portion 12 is exposed and the upper surface of the remain first silicon dioxide layer on the first portion 11 of the substrate and the upper surface of the second portion 12 of the substrate are substantially flat. Next, a second silicon dioxide layer Of 0.4 µm is entirely deposited by CVD method. Then, the silicon dioxide film 2 having the low thermal conductivity of 0.014 W/cm·deg. and including the first section 21 having the thickness tₛ of 4.0 µm and the second section 22 having the thickness t_{g} of 0.4 µm is constructed on the single silicon crystal substrate 1. Next, a polycrystalline silicon layer 3 of 0.6 µm thickness is entirely deposited on the silicon dioxide film 2 in a low-pressure CVD reactor by using monosilane (SiH₄) as a raw gas at 670°C to 730°C, for example, 700°C. In the polycrystalline silicon layer deposited under the conditions mentioned above, crystals having 〈100〉 texture are predominately produced than the other crystals having 〈111〉, 〈311〉 and 〈110〉 textures. The polycrystalline silicon layer 3 includes a first region 31 formed on the thick silicon dioxide film and a second region 32 formed on the thin silicon dioxide film. Next, a silicon nitride film 4 of 60 nm (600 Å) thickness is selectively formed only on the second region 32 of the polycrystalline silicon layer 3 as an anti-reflection film against a laser beam irradiation. Next, CW-Ar⁺ laser is irradiated and scanned on the polycrystalline silicon layer 3 from the first region 31 to the second region 32 along the arrow 50. In the laser annealing process, the structure including the substrate 1, the silicon dioxide film 2 and the silicon layer 3 is maintained at about 300°C, and the laser is constantly kept its beam diameter to 50 µm, its power to 8 watt, and its scan speed to 3 mm/second. As shown in Figs. 2A and 2B, a part 41 having the width d₁ of about 60 µm in the region 31 is annealed such that the silicon layer is partially molten state with solid state particles being floated in the molten state, that is, solid-liquid state. Silicon crystals obtained by the recrystallization becomes 5 to 10 µm in size and most of the silicon crystals 43 having 〈100〉 axis in a direction perpendicular to the surface of the silicon dioxide film 2 are predominately grown. The recrystallized silicon crystals in the part 41 can be used as seeds for forming a single silicon crystal in the second region. More particularly, to obtain the seeds mentioned above, solid-liquid state must be cooled slowly. According to the present invention, the thick and low thermal conductive material, that is, the section 21 of the silicon dioxide film 2 is provided in the silicon layer. Therefore, the heat by the laser beam is widely dispersed in the silicon layer laterally and a dwell time, which is a anneal width d₁ to scan speed ratio, becomes about 20 x 10⁻³ second. In the large dwell time condition, the temperature of the silicon is slowly increased and it is slowly decreased. Therefore, the dwell time is one of indications to obtain seeds and 20 x 10⁻³ second in the embodiment is a adequate value. Continuosuly, the laser beam is scanned on the second region 32 of the polycrystalline silicon layer 3 with the same laser conditions through the silicon nitride film 4. In the first region 31, the silicon nitride film 4 is not provided. Therefore, about 35% of the laser power is reflected from the surface of the silicon layer. On the other hand, in the second region 32 only about 5% of the laser power is reflected by providing the silicon nitride film 4. Therefore, the effeciency of introduction of the laser power into the polycrystalline silicon layer is enhanced, and the silicon layer is fully molten, that is, perfect liquid state at a second part 42 having the width d₂ of about 20 µm in the second region 32 of the silicon layer 3. Then, the molten state becomes recrystallized single silicon crystal layer 45 of about 20 µm width d₂ which is formed by using silicon crystal grains 43 in the first part 41 as a seed. The single silicon crystal layer 45 has a 〈100〉 axis in a direction perpendicular to the upper surface of the silicon dioxide film 2. The dwell time in the second region is about 7 x 10⁻³ second. The single silicon crystal layer 45 can be extended from the seeds area to 500 µm to 1 mm or more along the direction 50 of the laser scanning. After forming the single silicon crystal layer 45, the silicon nitride film 4 is removed, and semiconductor devices (not shown) are formed in the single silicon crystal layer 45. The recrystallized single silicon crystal layer made by the method was confirmed to have 〈100〉 axis in a direction perpendicular to the upper surface of the silicon dioxide film 2 and free from a grain boundary by an etching method, an electron channeling pattern (ECP) method and a transmission electron microscopy (TEM) method. In the embodiment, only one single silicon crystal layer 45 is explained. However, a plurality of single silicon crystal layers may be formed in the silicon layer by repeating the laser scannings. Further, the whole parts of the second silicon region 32 may be changed to the single silicon crystal layer. The anti-reflector film may be shaped as stripe line along the laser beam scanning direction, or else a groove may be formed in the second section 22 of the insulating film 2 to deposit the polycrystalline silicon therein and to form the single silicon crystal in the groove. The modifications are useful to provide the single silicon crystal in the designed position. The substrate may be of other materials having high thermal conductivity such as alumina, aluminum nitride, silicon carbide, beryllium oxide, sapphire and spinel.

## Claims

1. A method of manufacturing a single crystal silicon layer (45) comprising the steps of forming a substrate structure having a body member (1) of a material having a thermal conductivity of 0.2 W/cm·°C or more and an insulating film (2) having a thermal conductivity lower than that of said body member (1), said insulating film including a first section (21) having a first thickness and a second section (22) having a second thickness smaller than of said first thickness, depositing a polycrystalline silicon layer (3) on said first and second sections (21, 22) of said insulating film (2), said polycrystalline silicon layer including a first part (31) formed on said first section (21) of said insulating film (2) and a second part (32) formed on said second section (22) of said insulating film (2), forming an anti-reflection film (4) for a given laser beam on said polycrystalline silicon layer (3), and irradiating said polycristalline silicon layer (3) by scanning a laser beam over said first and second parts (31, 32) of said polycrystalline silicon layer (3), to recrystallize said second part (42) to form a single crystal region,
**characterized** in that
said step for forming said substrate structure includes a first step to dry etch said body member (1) to have a first portion (11) having an upper face and a second portion (12) having an upper face at a higher level than said upper face of said first portion (11), next a second step for depositing a first layer of insulating material entirely on said faces of said first and second portions (11, 12), next a third step for partially removing said first layer of insulating material such that said upper face of said second portion (12) of said body member (1) is exposed and that the upper face of the remaining first layer of insulating material on said first portion (11) and the exposed upper face of said second portion (12) are substantially flat, and next a fourth step for depositing entirely a second layer of insulating material with a uniform thickness such that said first section (21) of said insulating film (2) is constituted of said remaining first layer of insulating material and said second layer of insulating material and said second section (22) of said insulating film (2) is constituted of said second layer of insulating material only, and that the upper surfaces of first and second sections (21, 22) of said insulating film (2) are substantially co-planar;
said anti-reflection film (4) is formed only on said second part (32) of said polycrystalline silicon layer above said second section (22) of said insulating film and does not cover said first part (41) of said polycrystalline silicon layer above said first section (21) of said insulating film;
and irradiating said polycristalline silicon layer (3) by scanning said laser beam over said polycrystalline layer (3) from said first part (31) to said second part (32) with constant scan speed, power and beam diameter such that in a portion (41) of said first part (31) the polycrystalline layer (3) is partially melted to a state consisting of both solid and liquid states and crystalline silicon grains (43) having the 〈100〉 axis in a direction perpendicular to the surface of the insulating film (2) and having grain size of 5 to 10 µm are predominately grown in said portion (41) of said first part (31), and that in a portion (42) of said second part (32) the polycrystalline layer is completely melted to the liquid state and a single crystal silicon layer (45) having the 〈100〉 axis in a direction perpendicular to the surface of the insulating film (2) is grown in said portion (42) of said second part (32) from the boundary between said portions (41, 42) using said silicon grains (43) in said portion (41) of said first part (31) as seeds.

2. A method of claim 1 , in which said laser beam is a continuous wave Ar⁺ or CO₂ or YAG laser beam.

3. A method of claim 1 , in which said anti-reflection film is made of silicon nitride, or a composite film consisting of a silicon dioxide layer and a silicon nitride layer formed on said silicon dioxide layer.

4. A method of claim 1 , in which the thickness of said polycrystalline silicon layer ranges from 0.5 µm to 1.0 µm.

5. A method of claim 1 , in which said thermal conductivity of said insulating film is 0.05 W/cm·°C or less.

6. A method of claim 1 , in which the material of said body member is silicon, aluminium nitride, alumina, silicon carbide, beryllium oxide, sapphire or spinel.

7. A method of claim 1 , in which said insulating film is made of silicon dioxide.

## Patentansprüche

1. Verfahren zur Herstellung einer einkristallinen Siliziumschicht (45) mit den Schritten,
Ausbildung einer Substratstruktur mit einem Körperelement (1) eines Materials mit einer thermischen Leitfähigkeit von 0,2 W/cm°C oder mehr und eines Isolierfilmes (2) mit einer thermischen Leitfähigkeit, die geringer ist als die des Körperelementes (1), wobei der Isolierfilm einen ersten Abschnitt (21) mit einer ersten Dicke und einen zweiten Abschnitt (22) mit einer zweiten Dicke, die geringer als die erste Dicke ist, aufweist,
Abscheiden einer polykristallinen Polysiliziumschicht (3) auf den ersten und zweiten Abschnitten (21, 22) des Isolierfilms (2), wobei die polykristalline Siliziumschicht einen ersten Teil (31), der auf den ersten Abschnitt (21) des Isolierfilmes (2) ausgebildet ist, und einen zweiten Teil (32), der auf dem zweiten Abschnitt (22) des Isolierfilmes (2) ausgebildet ist, aufweist,
Ausbildung eines Antireflektionsfilmes (4) für einen gegebenen Laserstrahl auf der polykristallinen Siliziumschicht (3) und
Bestrahlen der polykristallinen Siliziumschicht (3) durch das Abtasten eines Laserstrahls über die ersten und zweiten Teile (31, 32) der polykristallinen Siliziumschicht (3), um den zweiten Teil (42) zu rekristallisieren und einen Einkristallbereich zu erzeugen,
dadurch **gekennzeichnet,**
daß der Schritt zur Ausbildung der Substratstruktur einen ersten Schritt zum Trockenätzen des Körperelementes (1) umfaßt, um einen ersten Bereich (11) mit einer oberen Fläche und einen zweiten Bereich (12) mit einer oberen Fläche auf einem höheren Pegel als die obere Fläche des ersten Bereichs (11) zu schaffen, als nächstes einen zweiten Schritt zum Abscheiden einer ersten Schicht aus Isoliermaterial auf den gesamten Flächen des ersten und des zweiten Bereichs (11, 12), als nächstes einen dritten Schritt zum teilweise Entfernen der ersten Schicht aus Isoliermaterial derart, daß die obere Fläche des zweiten Bereichs (12) des Körperelementes (1) freiliegt und dann die obere Fläche der verbleibenden ersten Schicht aus Isoliermaterial auf dem ersten Bereich (11) und die freiliegende obere Fläche des zweiten Bereichs (12) im wesentlichen flach sind, und als nächstes einen vierten Schritt zur vollständigen Abscheidung einer zweiten Schicht aus Isoliermaterial mit gleichförmiger Dicke derart, daß der erste Abschnitt (21) des Isolierfilmes (2) aus der verbleibenden ersten Schicht aus Isoliermaterial und der zweiten Schicht aus Isoliermaterial gebildet ist, und der zweite Abschnitt (22) des Isolierfilmes (2) nur durch die zweite Schicht des Isoliermaterials gebildet ist und daß die oberen Flächen der ersten und zweiten Abschnitte (21, 22) des Isolierfilms (2) im wesentlichen coplanar sind,
daß der Antireflektionsfilm (4) nur auf dem zweiten Teil (32) der polykristallinen Siliziumschicht oberhalb des zweiten Abschnittes (22) des Isolierfilms gebildet wird und den ersten Teil (41) der polykristallinen Siliziumschicht oberhalb des ersten Abschnittes (21) des Isolierfilmes nicht abdeckt,
und Bestrahlen der polykristallinen Siliziumschicht (3) durch Abtasten mit einem Laserstrahl über die polykristalline Siliziumschicht (3) vom ersten Teil (31) zum zweiten Teil (32) mit konstanter Abtastgeschwindigkeit, wobei die Leistung und der Strahldurchmesser derart sind, daß in einem Bereich (41) des ersten Teils (31) die polykristalline Siliziumschicht (3) teilweise zu einem Zustand geschmolzen wird, der sowohl aus festen als auch flüssigen Phasen besteht, wobei die kristallinen Siliziumkörner (43), deren 〈100〉-Achse in einer Richtung senkrecht zur Oberfläche des Isolierfilms (2) liegen und die eine Korngröße von 5 - 10 µm aufweisen, bevorzugt in dem Bereich (41) des ersten Teils (31) wachsen und daß in einem Bereich (42) des zweiten Teils (32) die polykristalline Schicht vollständig in den flüssigen Zustand aufgeschmolzen wird und eine einkristalline Siliziumschicht (45), deren 〈100〉-Achse in einer Richtung senkrecht zur Oberfläche des Isolierfilms (2) liegt, in dem Bereich (42) des zweiten Teils (32) von der Grenze zwischen den Bereichen (41, 42) unter Verwendung der Siliziumkörner (43) in dem Bereich (41) des ersten Teils (31) als Keime wächst.

2. Verfahren nach Anspruch 1, wobei der Laserstrahl ein Dauerstrich-Laserstrahl eines Ar⁺ oder eines CO₂ oder eines YAG-Lasers ist.

3. Verfahren nach Anspruch 1, wobei der Antireflektionsfilm aus Siliziumnitrid oder einem zusammengesetzen Film aus einer Siliziumoxidschicht und einer Siliziumnitridschicht, die auf der Siliziumdioxidschicht ausgebildet ist, hergestellt ist.

4. Verfahren nach Anspruch 1, wobei die Dicke der polykristallinen Siliziumschicht im Bereich von 0,5 µm bis 1,0 µm liegt.

5. Verfahren nach Anspruch 1, wobei die thermische Leitfähigkeit des Isolierfilmes 0,05 W/cm°C oder weniger beträgt.

6. Verfahren nach Anspruch 1, wobei das Material des Körperelementes Silizium, Aluminiumnitrid, Aluminiumoxid, Siliziumkarbid, Berylliumoxid, Saphir oder Spinell ist.

7. Verfahren nach Anspruch 1, wobei der Isolierfilm aus Siliziumdioxid hergestellt ist.

## Revendications

1. Procédé pour fabriquer une couche de silicium monocristallin (45) comprenant les étapes consistant à former une structure de substrat ayant un élément de corps (1) d'un matériau présentant une conductivité thermique de 0,2 W/cm·deg ou plus et d'un film isolant (2) ayant une conductivité thermique inférieure à celle de l'élément de corps (1), le film isolant comportant une première section (21) ayant une première épaisseur et une seconde section (22) ayant une seconde épaisseur inférieure à la première épaisseur, déposer une couche de silicium polycristallin (3) sur les première et seconde sections (21, 22) du film isolant (2), la couche de silicium polycristallin comportant une première partie (31) formée sur la première section (21) du film isolant (2) et une seconde partie (32) formée sur la seconde section (22) du film isolant (2), former un film anti-réfléchissant (4) pour un faisceau laser donné sur la couche de silicium polycristallin (3) et irradier la couche de silicium polycristallin (3) par balayage par un faisceau laser sur les première et seconde parties (31, 32) de la couche de silicium polycristallin (3), afin de recristalliser la seconde partie (42) pour former une région monocristalline,
caractérisé en ce que
l'étape pour former la structure de substrat comporte une première étape consistant à graver à sec l'élément de corps (1) pour avoir une première partie (11) ayant une face supérieure et une seconde partie (12) ayant une face supérieure à un niveau plus haut que la face supérieure de la première partie (11), puis une seconde étape consistant à déposer une première couche de matériau isolant entièrement sur les faces des première et seconde parties (11, 12), puis une troisième étape consistant à enlever partiellement la première couche de matériau isolant de manière telle que la face supérieure de la seconde partie (12) de l'élément de corps (1) est exposée et que la face supérieure de la première couche restante de matériau isolant sur la première partie (11) et la face supérieure exposée de la seconde partie (12) sont pratiquement plates, et puis une quatrième étape consistant à déposer entièrement une seconde couche de matériau isolant avec une épaisseur uniforme d'une manière telle que la première section (21) du film isolant (2) est constituée de la première couche restante de matériau isolant et de la seconde couche de matériau isolant et que la seconde section (22) du film isolant (2) est constituée seulement de la seconde couche de matériau isolant, et les surfaces supérieures des première et seconde sections (21, 22) dudit film isolant (2) sont pratiquement coplanaires :
le film anti-réfléchissant (4) est formé seulement sur la seconde partie (32) de la couche de silicium polycristallin au-dessus de la seconde section (22) du film isolant et ne recouvre pas la première partie (41) de la couche de silicium polycristallin au-dessus de la première section (21) du film isolant ;
et à irradier la couche de silicium polycristallin (3) en déplaçant le faisceau laser sur la couche de silicium polycristallin (3) à partir de la première partie (31) à la seconde partie (32) avec une vitesse de balayage constante, une puissance et un diamètre de faisceau constants d'une manière telle que dans une portion (41) de la première partie (31) la couche polycristalline (3) est partiellement fondue à un état consistant à la fois des états solide et liquide et les grains de silicium cristallin (43) ayant l'axe 〈100〉 dans un sens perpendiculaire à la surface du film isolant (2) et ayant des dimensions de grains de 5 à 10 µm sont mis à croître principalement dans la portion (41) de ladite première partie (31), et en ce que dans une portion (42) de la seconde partie (32), la couche polycristalline est totalement fondue à l'état liquide et une couche de silicium monocristallin (45) ayant l'axe 〈100〉 dans un sens perpendiculaire à la surface du film isolant (2) est mise à croître dans la portion (42) de la seconde partie (32) à partir de la limite entre les parties (41, 42) utilisant les grains de silicium (43) dans ladite partie (41) de la première partie (31) comme germes.

2. Procédé selon la revendication 1, dans lequel le faisceau laser est un faisceau laser en régime continu de Ar⁺ ou un faisceau laser CO₂ ou YAG.

3. Procédé selon la revendication 1, dans lequel le film anti-réfléchissant est constitué de nitrure de silicium, ou d'un film composé constitué d'une couche de dioxyde de silicium et d'une couche de nitrure de silicium formée sur la couche de dioxyde de silicium.

4. Procédé selon la revendication 1, dans lequel l'épaisseur de la couche de silicium polycristallin s'étale de 0,5 µm à 1,0 µm.

5. Procédé selon la revendication 1, dans lequel la conductivité thermique du film isolant est de 0,05 W/cm·deg ou moins.

6. Procédé selon la revendication 1, dans lequel le matériau de l'élément de corps est du silicium, du nitrure d'aluminium, de l'oxyde d'aluminium, du carbure de silicium, de l'oxyde de béryllium, du saphir ou du spinelle.

7. Procédé selon la revendication 1, dans lequel le film isolant est constitué de dioxyde de silicium.
